# DEMANDE DE BREVET EUROPEEN

(11) **EP 4 187 269 A1**
(43) Date de publication de la demande: **31.05.2023**
(21) Numéro de dépôt: 22207669.7
(22) Date de dépôt: 16.11.2022
(51) Int. Cl.: G01R 31/54

(54) **DISPOSITIF DE DÉTECTION DE RUPTURE D'UN CÂBLE ÉLECTRIQUE ET PROCÉDÉ DE FONCTIONNEMENT ASSOCIÉ**

(30) Priorité: 25.11.2021 FR 2112535
(71) Demandeur: Nexans, 92400 Courbevoie (FR)
(72) Inventeur: POULIN, Nicolas, 62138 Auchy-les-Mines (FR)
(74) Mandataire: Ipsilon

(57) **Abrégé**

Ce dispositif (10) de détection de rupture d'au moins un câble électrique (12) comporte l'au moins un câble électrique (12), un capteur (14) sans fil connecté à l'au moins un câble électrique (12), au moins une unité (18) d'alimentation en énergie alimentant le capteur (14) sans fil. L'au moins une unité (18) d'alimentation en énergie comporte un moyen (20) d'application d'un potentiel prédéterminé à l'au moins un câble électrique (12) et le capteur (14) sans fil est adapté à détecter, soit le potentiel prédéterminé, indicateur de l'intégrité de l'au moins un câble électrique (12), soit un potentiel flottant, indicateur de la rupture de l'au moins un câble électrique (12).

## Description

La présente invention se rapporte à un dispositif antivol de câble électrique ainsi qu'à un procédé de fonctionnement associé.

L'invention appartient au domaine des câbles électriques et des dispositifs de protection contre le vol ou autre cas de rupture non prévue de tels câbles.

Il arrive en effet qu'avant leur mise sous tension, des câbles ou des segments de câbles fassent l'objet d'un vol ou autre malveillance causant leur rupture, par exemple lorsqu'ils sont entreposés dans des tranchées, à même le sol ou à faible hauteur, dans l'attente d'être installés.

Ces ruptures malveillantes des câbles peuvent également intervenir après installation des câbles mais avant mise sous tension, en particulier si les câbles ne sont pas enterrés et se trouvent à des hauteurs aisément accessibles.

Afin de permettre une intervention suffisamment tôt pour que les câbles ne soient pas dérobés, il existe des dispositifs antivol de câbles.

On connaît par exemple par le document ES-U-1 198 360 un dispositif de détection de vol de câble d'éclairage. Une rupture dans le câblage du réseau électrique qui alimente l'installation d'éclairage comportant ce câble d'éclairage, due à une tentative de vol de ce câble d'éclairage, est détectée, soit pendant la journée, en l'absence d'éclairage, via la détection de la résistance électrique de la ligne de câble concernée, soit pendant la nuit, via la détection de l'intensité électrique du courant qui parcourt le câble. Un message d'alerte est alors envoyé sous forme de SMS à un terminal mobile donné.

Un tel dispositif présente diverses limites. Tout d'abord, il est nécessaire que le câble surveillé soit sous tension pour que ce dispositif antivol, fondé sur la détection d'une résistance électrique ou d'une intensité électrique, fonctionne. Par ailleurs, son principe de fonctionnement est lié à la nature des câbles surveillés, qui sont des câbles d'éclairage. Il ne s'applique donc pas à tout type de câble.

La présente invention a pour but de remédier aux inconvénients précités de l'art antérieur.

Dans ce but, la présente invention propose un dispositif de détection de rupture d'au moins un câble électrique, ce dispositif comportant :
l'au moins un câble électrique,
un capteur sans fil connecté à l'au moins un câble électrique,
au moins une unité d'alimentation en énergie alimentant le capteur sans fil,
le dispositif étant remarquable en ce que :
   l'au moins une unité d'alimentation en énergie comporte un moyen d'application d'un potentiel prédéterminé à l'au moins un câble électrique ; et
   le capteur sans fil est adapté à détecter, soit le potentiel prédéterminé, indicateur de l'intégrité de l'au moins un câble électrique, soit un potentiel flottant, indicateur de la rupture de l'au moins un câble électrique.

Ainsi, la rupture du câble provoque la perte du potentiel prédéterminé qui lui était appliqué et l'apparition d'un potentiel flottant, détecté immédiatement et de façon simple par le capteur sans fil. Cela permet de limiter les réparations et les retards à l'installation au cas où le câble sectionné n'était pas encore installé, voire les arrêts de production pour les utilisateurs, si le câble était déjà en cours d'exploitation.

En outre, ce dispositif est particulièrement adapté au cas d'un grand nombre de câbles à surveiller, sachant qu'aucun câblage n'est requis pour l'installation d'un capteur sans fil par câble électrique à surveiller. Cela permet une installation propre et aisée, contrairement aux dispositifs de surveillance comportant des éléments filaires à raccorder.

Dans un mode particulier de réalisation, le dispositif comporte en outre une unité d'émission de signaux radiofréquence adaptée à émettre des signaux qui diffèrent selon que le potentiel détecté est le potentiel prédéterminé ou le potentiel flottant.

Cela permet au dispositif d'émettre un signal alertant de la détection effectuée. Ainsi, à réception de l'alerte, toute mesure d'intervention appropriée peut être prise par les personnels responsables du câble électrique en question.

Dans ce mode de réalisation, le dispositif peut comporter en outre un module de communication connecté au capteur sans fil et à l'unité d'émission de signaux radiofréquence.

Un tel module de communication est optionnel. Il peut être prévu en variante à un mode d'échange direct de données entre le capteur sans fil et l'unité d'émission de signaux radiofréquence.

Dans un mode particulier de réalisation où le dispositif comporte l'unité d'émission de signaux radiofréquence précitée, cette unité d'émission peut faire partie intégrante du capteur sans fil. Cela rend le dispositif plus compact, avec moins de composants.

Dans un mode particulier de réalisation où le dispositif comporte l'unité d'émission de signaux radiofréquence précitée, cette unité d'émission de signaux radiofréquence peut comporter au moins une antenne. Cela permet l'émission des signaux par voie aérienne vers un réseau de communication filaire ou sans fil, par exemple pour la transmission de l'alerte à la suite de la détection de rupture du câble électrique.

Dans un mode particulier de réalisation, le dispositif comporte en outre une unité de stockage d'énergie fournissant de l'énergie à l'unité d'alimentation en énergie.

Cela permet au dispositif d'être autonome en énergie et de pouvoir fonctionner même en l'absence d'alimentation secteur dans la zone où se situe le câble électrique.

Dans ce mode de réalisation, selon une caractéristique particulière éventuelle mais non nécessaire, le dispositif peut comporter en outre une unité d'adaptation de puissance connectée à l'unité de stockage d'énergie et à l'unité d'alimentation en énergie et fournissant à l'unité d'alimentation en énergie une puissance adaptée à partir de la puissance reçue en provenance de l'unité de stockage d'énergie.

Cet étage d'adaptation de puissance permet la compatibilité entre divers types d'unités de stockage d'énergie et divers types d'unités d'alimentation en énergie.

Dans le même but que celui indiqué plus haut, la présente invention propose également un procédé de détection de rupture d'au moins un câble électrique, ce procédé étant remarquable en ce qu'il comporte des étapes consistant à :
appliquer un potentiel prédéterminé à l'au moins un câble électrique ;
détecter, par l'intermédiaire d'un capteur sans fil connecté à l'au moins un câble électrique, soit le potentiel prédéterminé, indicateur de l'intégrité de l'au moins un câble électrique, soit un potentiel flottant, indicateur de la rupture de l'au moins un câble électrique.

Dans un mode particulier de réalisation, le procédé comporte en outre une étape consistant à envoyer un signal d'alerte en cas de détection du potentiel flottant précité.

Dans ce mode de réalisation, selon une caractéristique particulière possible mais non nécessaire, l'étape d'envoi du signal d'alerte peut comporter l'envoi d'un message à un terminal mobile de télécommunications, par l'intermédiaire d'un réseau de télécommunications.

Les caractéristiques particulières et les avantages du procédé étant similaires à ceux du dispositif, ils ne sont pas répétés ici.

### Brève description des dessins

D'autres aspects et avantages de l'invention apparaîtront à la lecture de la description détaillée ci-après de modes particuliers de réalisation, donnés à titre d'exemples nullement limitatifs, en référence aux dessins annexés, dans lesquels :
[Fig. 1] est une représentation schématique d'un dispositif de détection de rupture de câble électrique conforme à la présente invention, dans un mode particulier de réalisation où le dispositif comporte deux câbles électriques ;
[Fig. 2] est une représentation schématique simplifiée comparative d'un dispositif conforme à la présente invention dans un état où le câble est intègre et dans un état où le câble est sectionné, dans un mode particulier de réalisation où le dispositif comporte un seul câble électrique ; et
[Fig. 3] est un organigramme illustrant des étapes d'un procédé de détection de rupture de câble électrique conforme à la présente invention, dans un mode particulier de réalisation.

### Description de mode(s) de réalisation

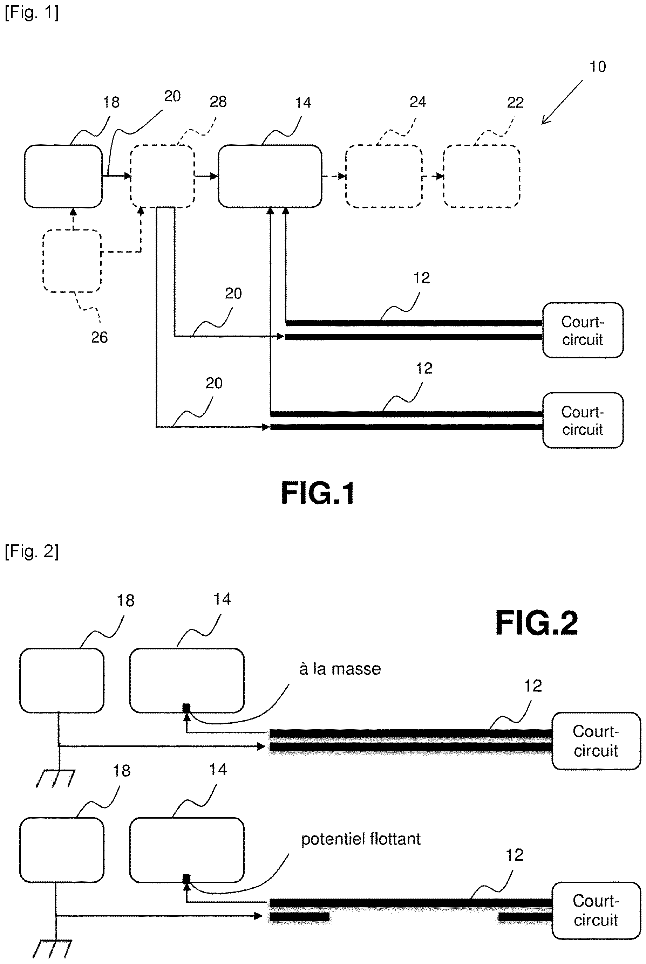

La figure 1 montre une vue schématique d'un dispositif 10 de détection de rupture de câble électrique conforme à la présente invention, dans un mode particulier de réalisation où le dispositif 10 comporte deux câbles électriques 12 à surveiller. Ce nombre particulier de câbles électriques 12 n'est qu'un exemple parmi d'autres, le nombre de câbles pouvant être quelconque.

Le câble électrique 12 considéré peut par exemple être un câble électrique de puissance, destiné par exemple au transport d'énergie et/ou à la transmission de données, comme par exemple un câble de signalisation.

A titre d'exemple non limitatif, il peut s'agir d'un câble de plusieurs kilomètres de longueur, destiné à être enterré dans une tranchée, entre deux stations ou sous-stations d'une infrastructure de fourniture d'énergie.

Outre ce ou ces câble(s) 12, le dispositif 10 comporte un ou plusieurs capteurs 14 sans fil.

Les capteurs 14 sans fil sont par exemple équipés de la technologie Bluetooth (marque déposée) ou équivalent.

Chaque capteur 14 sans fil est connecté à un câble électrique 12.

Le dispositif 10 comporte par ailleurs une ou plusieurs unité(s) 18 d'alimentation en énergie alimentant le ou les capteur(s) 14 sans fil.

Dans le mode particulier de réalisation de la figure 1, le dispositif 10 comporte une unité 18 d'alimentation en énergie alimentant le capteur 14 sans fil. En variante, plusieurs unités 18 d'alimentation en énergie peuvent alimenter un même capteur 14 sans fil.

Conformément à la présente invention, l'unité 18 d'alimentation en énergie comporte un moyen 20 d'application d'un potentiel prédéterminé au câble électrique 12 et le capteur 14 sans fil est adapté à détecter, soit ce potentiel prédéterminé, soit un potentiel flottant.

En effet, comme le montre la figure 1, le dispositif 10 est connecté, via son unité 18 d'alimentation en énergie et son capteur 14 sans fil, à deux conducteurs de chaque câble 12 et un court-circuit est établi à l'autre extrémité du câble 12.

Le potentiel prédéterminé, c'est-à-dire une valeur prédéterminée de potentiel détectée par le moyen 20 aux bornes du câble 12 surveillé, indique que le câble électrique 12 auquel le capteur 14 sans fil est connecté est intègre, autrement dit non endommagé et notamment non sectionné pour être dérobé.

En revanche, le potentiel flottant, c'est-à-dire une valeur indéterminée de potentiel détectée par le moyen 20 aux bornes du câble 12 surveillé, indique que le câble électrique 12 auquel le capteur 14 sans fil est connecté a subi une dégradation, par exemple une rupture.

Ainsi, chaque capteur 14 sans fil est adapté à détecter, soit un premier potentiel prédéterminé, indicateur de l'intégrité du câble électrique 12 auquel il est connecté, soit un potentiel flottant, indicateur de la rupture de ce même câble électrique 12.

A titre d'exemple nullement limitatif, de façon générale, le potentiel prédéterminé peut être nul, c'est-à-dire qu'un câble électrique 12 surveillé par le dispositif 10 peut être relié à la masse.

La figure 2 illustre un exemple de ce type, où le dispositif 10 comporte un seul câble électrique 12 qui se voit appliquer un potentiel nul lorsqu'il est intègre (schéma du haut sur le dessin) et présente un potentiel flottant en cas de rupture (schéma du bas sur le dessin).

Comme le montre la figure 1, le dispositif 10 peut comporter en outre un ou plusieurs des éléments optionnels 22, 24, 26 et 28, représentés en tirets sur le dessin et décrits ci-dessous. Il est à noter que dans le mode de réalisation de la figure 2, le dispositif 10 ne comporte aucun de ces éléments optionnels 22, 24, 26 et 28.

Ainsi, dans un mode particulier de réalisation, le dispositif 10 comporte en outre, de façon optionnelle, une unité 22 d'émission de signaux radiofréquence adaptée à émettre des signaux qui diffèrent selon que le potentiel détecté est le potentiel prédéterminé ou le potentiel flottant.

Dans ce mode particulier de réalisation, le dispositif 10 peut de plus comporter, de façon optionnelle, un module 24 de communication connecté au capteur 14 sans fil et à l'unité 22 d'émission de signaux radiofréquence.

En variante, l'unité 22 d'émission de signaux radiofréquence peut être intégrée dans le capteur 14 sans fil. Par exemple, lorsque les capteurs 14 sans fil sont équipés de la technologie Bluetooth (marque déposée), il peut être prévu une passerelle Bluetooth (marque déposée) pour communiquer avec l'ensemble des capteurs 14 sans fil et émettre des signaux radiofréquence par voie aérienne vers un réseau de télécommunications mobiles, par exemple du type GSM (acronyme anglais signifiant « Global System for Mobile Communications », système mondial de communication avec les mobiles). Ainsi, en cas de détection de rupture d'un câble surveillé, un signal d'alerte peut être envoyé par la passerelle sur le réseau GSM, par exemple par texto, à destination d'un terminal mobile ou d'une base de données.

Dans un mode particulier de réalisation où le dispositif 10 comporte une unité 22 d'émission de signaux radiofréquence, cette unité 22 d'émission de signaux radiofréquence peut comporter une ou plusieurs antenne(s), adaptée(s) à émettre ces signaux radiofréquence par voie aérienne vers l'extérieur du dispositif 10.

Comme l'illustre la figure 1, à titre optionnel, le dispositif 10 peut également comporter une unité 26 de stockage d'énergie. Il peut s'agir par exemple d'une batterie ou pile tout autre moyen d'accumulation d'énergie, y compris de type photovoltaïque.

L'unité 26 de stockage d'énergie fournit de l'énergie à l'unité 18 d'alimentation en énergie, ce qui permet au dispositif 10 de fonctionner en l'absence de tout raccordement au secteur et de toute autre source d'énergie à proximité de l'emplacement du dispositif 10 et en particulier à proximité de l'emplacement du ou des câble(s) 12 à surveiller.

Comme mentionné plus haut, cela est utile lorsque par exemple, une longueur de plusieurs kilomètres de câble 12 est entreposée entre deux stations ou sous-stations d'une infrastructure de fourniture d'énergie électrique, avant d'être installée et reliée à ces deux stations ou sous-stations.

Dans un mode particulier de réalisation où le dispositif 10 comporte une telle unité 26 de stockage d'énergie, toujours de façon optionnelle, le dispositif 10 peut comporter en outre une unité 28 d'adaptation de puissance.

Comme l'illustre la figure 1, l'unité 28 d'adaptation de puissance est connectée à l'unité 26 de stockage d'énergie et à l'unité 18 d'alimentation en énergie et fournit à l'unité 18 d'alimentation en énergie une puissance adaptée à partir de la puissance reçue en provenance de l'unité 26 de stockage d'énergie.

Dans ce mode de réalisation, le moyen 20 précité d'application d'un potentiel prédéterminé au câble électrique 12, compris dans l'unité 18 d'alimentation en énergie, fournit ce potentiel à l'unité 28 d'adaptation de puissance, qui l'applique au câble électrique 12 à surveiller. Lorsque le dispositif 10 ne comporte pas d'unité 28 d'adaptation de puissance, le moyen 20 applique le potentiel directement au câble électrique 12 à surveiller. Sur la figure 1, cela est matérialisé par des flèches entre l'unité 18 d'alimentation en énergie, l'unité 28 d'adaptation de puissance et les câbles électriques 12.

Dans un mode de réalisation où le dispositif 10 comporte une unité 22 d'émission de signaux radiofréquence, un signal de suivi peut être émis par l'unité 22 d'émission sous forme d'un message de « bonne santé » du câble électrique 12 surveillé, à destination d'un élément choisi de réception, tel qu'un terminal de télécommunications fixe ou mobile, par l'intermédiaire d'un réseau de télécommunications filaire ou sans fil.

A titre d'exemple nullement limitatif, le réseau peut être un réseau de type GSM ou tout autre type de réseau de communication.

A titre d'exemple non limitatif, on peut prévoir l'émission d'un tel signal de suivi à une certaine périodicité, par exemple une fois par jour.

Dans un mode de réalisation où l'unité 22 d'émission comporte une antenne, le signal de suivi est émis par l'antenne par voie aérienne.

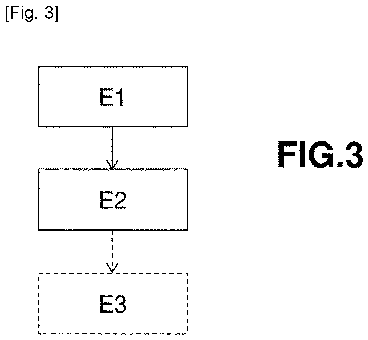

L'organigramme de la figure 3 illustre des étapes d'un procédé de détection de rupture d'au moins un câble électrique 12.

Conformément à la présente invention, ce procédé comporte une étape E1 consistant à appliquer le potentiel prédéterminé précité au câble électrique 12 et une étape subséquente E2 consistant à détecter, par l'intermédiaire du capteur 14 sans fil connecté au câble électrique 12, soit le potentiel prédéterminé, indicateur de l'intégrité de ce câble électrique 12, soit un potentiel flottant, indicateur de la rupture de ce même câble électrique 12.

De façon optionnelle, comme illustré en tirets sur la figure 3, le procédé peut comporter en outre une étape E3 postérieure à l'étape E2 consistant à envoyer un signal d'alerte en cas de détection du potentiel flottant précité.

Dans un mode particulier de réalisation, l'étape E3 d'envoi du signal d'alerte peut comporter l'envoi d'un message à un terminal mobile de télécommunications, par l'intermédiaire d'un réseau de télécommunications. A titre d'exemple non limitatif, le message peut être envoyé sous forme d'un texto. Cet envoi ne nécessite donc pas d'accès au réseau Internet dans le déroulement des étapes du procédé de détection conforme à l'invention. En revanche, de façon optionnelle, à partir d'un message d'alerte sous forme de texto, un site Internet lié au réseau de télécommunications précité peut, à partir de ce texto, envoyer un courriel à une adresse prédéfinie.

La présente invention permet de surveiller l'intégrité de câbles électriques à distance et de façon simple, efficace, peu coûteuse et économique en énergie et en moyens humains, sans qu'il soit nécessaire de modifier le processus de fabrication de ces câbles.

## Revendications

1. Dispositif (10) de détection de rupture d'au moins un câble électrique (12), ledit dispositif (10) comportant :
ledit au moins un câble électrique (12),
un capteur (14) sans fil connecté audit au moins un câble électrique (12),
au moins une unité (18) d'alimentation en énergie alimentant ledit capteur (14) sans fil,
ledit dispositif étant **caractérisé en ce que** :
ladite au moins une unité (18) d'alimentation en énergie comporte un moyen (20) d'application d'un potentiel prédéterminé audit au moins un câble électrique (12) ; et
ledit capteur (14) sans fil est adapté à détecter, soit ledit potentiel prédéterminé, indicateur de l'intégrité dudit au moins un câble électrique (12), soit un potentiel flottant, indicateur de ladite rupture dudit au moins un câble électrique (12).

2. Dispositif (10) selon la revendication 1, **caractérisé en ce qu'**il comporte en outre une unité (22) d'émission de signaux radiofréquence adaptée à émettre des signaux qui diffèrent selon que le potentiel détecté est ledit potentiel prédéterminé ou ledit potentiel flottant.

3. Dispositif (10) selon la revendication 2, **caractérisé en ce qu'**il comporte en outre un module (24) de communication connecté audit capteur (14) sans fil et à ladite unité (22) d'émission de signaux radiofréquence.

4. Dispositif (10) selon la revendication 2, **caractérisé en ce que** ledit capteur (14) sans fil comporte ladite unité (22) d'émission de signaux radiofréquence.

5. Dispositif (10) selon l'une quelconque des revendications 2 à 4, **caractérisé en ce que** ladite unité (22) d'émission de signaux radiofréquence comporte au moins une antenne.

6. Dispositif (10) selon l'une quelconque des revendications précédentes, **caractérisé en ce qu'**il comporte en outre une unité (26) de stockage d'énergie fournissant de l'énergie à ladite unité (18) d'alimentation en énergie.

7. Dispositif (10) selon la revendication précédente, **caractérisé en ce qu'**il comporte en outre une unité (28) d'adaptation de puissance connectée à ladite unité (26) de stockage d'énergie et à ladite unité (18) d'alimentation en énergie et fournissant à ladite unité (18) d'alimentation en énergie une puissance adaptée à partir de la puissance reçue en provenance de ladite unité (26) de stockage d'énergie.

8. Procédé de détection de rupture d'au moins un câble électrique (12), ledit procédé étant **caractérisé en ce qu'**il comporte des étapes consistant à :
appliquer (E1) un potentiel prédéterminé audit au moins un câble électrique (12) ;
détecter (E2), par l'intermédiaire d'un capteur (14) sans fil connecté audit au moins un câble électrique (12), soit ledit potentiel prédéterminé, indicateur de l'intégrité dudit au moins un câble électrique (12), soit un potentiel flottant, indicateur de ladite rupture dudit au moins un câble électrique (12).

9. Procédé selon la revendication précédente, **caractérisé en ce qu'**il comporte en outre une étape (E3) consistant à envoyer un signal d'alerte en cas de détection dudit potentiel flottant.

10. Procédé selon la revendication précédente, **caractérisé en ce que** ladite étape (E3) d'envoi dudit signal d'alerte comporte l'envoi d'un message à un terminal mobile de télécommunications, par l'intermédiaire d'un réseau de télécommunications.
